# EUROPÄISCHE PATENTSCHRIFT

(11) **EP 3 593 379 B1**
(45) Veröffentlichungstag und Bekanntmachung des Hinweises auf die Patenterteilung: **16.08.2023**
(21) Anmeldenummer: 17710212.6
(22) Anmeldetag: 09.03.2017
(51) Int. Cl.: H01L 21/683, H01L 21/687

(54) **ELEKTROSTATISCHE SUBSTRATHALTERUNG**
ELEKTROSTATIC SUBSTRATE HOLDER
SUPPORT DE SUBSTRAT ÉLECTROSTATIQUE

(43) Veröffentlichungstag der Anmeldung: 15.01.2020
(73) Patentinhaber: EV Group E. Thallner GmbH, St. Florian am Inn (AT)
(72) Erfinder: FLÖTGEN, Christoph, 4782 St.Florian am Inn (AT)
(74) Vertreter: Schneider, Sascha
(86) Internationale Anmeldenummer: PCT/EP2017/055608
(87) Internationale Veröffentlichungsnummer: WO 2018/162070

(56) Entgegenhaltungen:
- EP-A2- 0 725 427
- WO-A1-2016/137964
- JP-A- 2011 181 873
- KR-A- 20150 003 978
- US-A- 5 827 080
- US-A1- 2003 035 088
- US-A1- 2005 016 685
- US-A1- 2014 083 977

## Beschreibung

Die Marktanforderungen nach leistungsfähigeren elektronischen Geräten erfordert neuartige Herstellungs- sowie Bearbeitungsverfahren für die entsprechenden funktionellen Einheiten. Diese Leistungsfähigkeit kann in erhöhter Rechenkapazität, in empfindlichere Sensorik wie Bilderfassung, schnellere und größere Speicherbausteine aber auch größere Schaltströme oder höhere Frequenzen bei IGBT-Elementen, hellere, farbige bzw. farbigere LEDs definiert werden.

Druckschrift US 5827080 A offenbart eine elektrostatische Substrathalterung. Druckschrift WO 2016/137964 A1 offenbart eine elektrostatische Substrathalterung, wobei die Elektroden zur Erzeugung einer elektrostatischen Haltekraft zur Fixierung des Substrats im Rotor angeordnet sind.

In den meisten Fällen kommt eine erhöhte Leistung mit vermehrter Energieumsetzung zustande, wodurch die Wärmeverluste ebenfalls höher ausfallen. Um eine Überhitzung zu vermeiden sind einerseits Kühlung, andererseits die Reduktion des Volumens und eine Erhöhung der Oberfläche zielführend. Eine Volumenreduktion von Chips ist in der lateralen Richtung technologisch begrenzt, da die Miniaturisierung nicht beliebig vorangetrieben werden kann. Die physikalischen Rahmenparameter treten mehr und mehr als harte Grenzen der einzelnen Technologien auf. Um das Chipvolumen zu reduzieren ist es ein sinnvoller Schritt, die Chips und/oder die Träger, auch Substrate genannt, zu dünnen.

Je dünner ein Substrat ist, desto brüchiger ist es. Die Brüchigkeit stellt besondere Anforderungen an die Handhabung der Substrate. Um Substratbrüchen vorzubeugen und eine Massenfertigung zu ermöglichen, sind besondere Maßnahmen erforderlich, welche das Festhalten des Substrats sowie die Prozessierung beinhalten.

Rückgedünnte Substrate müssen auf die ursprüngliche, bevorzugt ebene Form gebracht und darin gehalten werden, weil rückgedünnte Substrate ohne Stützung individuelle Formen aufnehmen, sich sogar aufrollen können. Grund dafür ist, dass die lokalen atomaren Verhältnisse nicht kontrollierbar sind und diese auch die Formgebung durch mechanische Spannungszustände beeinflussen.

Die Definition einer Ebene kann im mathematischen Sinne erfolgen oder in der Halbleitertechnik gemäß Semi-Standards, welche die zulässigen Abweichungen im Rahmen der Toleranzen festlegt. Diese Definitionen sind dem Fachmann des einschlägigen Bereichs bekannt.

Die Industrie hat zur Befestigung und Begradigung verformter Substrate mehrere Ansätze und Lösungen auch unter den Namen Substrathandling oder Haltevorrichtung entwickelt. Vgl. die Verwendung von Trägersubstraten, vgl. US8449716B2 sowie die dazugehörenden Aufbau- und Verbindungstechnologien.

Im Folgenden wird auf einige Nachteile des Stands der Technik eingegangen. Die meisten Haltevorrichtungen im Stand der Technik sind nicht oder nur bedingt für Vakuum geeignet.

Eine Möglichkeit einer Haltevorrichtung verwendet die chemische Adhäsion für die Befestigung des Substrats auf einem Träger. Für Technologieschritte, welche bei erhöhten Temperaturen (über 200°C, bevorzugter über 300°C, besonders bevorzugt über 350°C, ganz besonders bevorzugt über 400°C) und/oder in Vakuum ausgeführt werden, ist die Verwendung von insbesondere ausgasenden Polymerverbindungen und/oder Klebstoffen, und/oder Lote nachteilig.

Eine weitere Möglichkeit einer Haltevorrichtung besteht darin, die Substrate oder ein Substrat, insbesondere ein rückgedünntes Substrat, mittels schwachen atomaren Kräften und/oder Oberflächenadhäsion festzuhalten. Das Anhaften des dünnen Substrats auf dem Träger sowie das Lösen stellt insbesondere bei Anwendungen bei erhöhten Temperaturen und/oder Vakuum eine Herausforderung dar.

Eine weitere Möglichkeit besteht darin, ein insbesondere rückgedünntes Substrat mechanisch zu befestigen. Die Haltekraft kann mittels Greifer erzeugt werden. Dies ist jedoch wegen Reinheitskriterien und der Empfindlichkeit der hergestellten Strukturen oft nicht erwünscht.

Eine weitere Ausführungsform der Haltevorrichtung verwendet in vielen Fällen die fluidische Krafterzeugung, wobei entweder Strömungsverhältnisse mit Druckdifferenzen erzeugt werden, sodass der externe Druck das Substrat auf der Haltevorrichtung andrückt. Es können Bernoulli-Aktuatoren mit Luftpolster oder saugende Halteflächen angewendet werden. Die Ausführungsformen sowie Ausgestaltung solcher Systeme sind dem Fachmann des einschlägigen Gebietes bekannt.

Man erkennt, dass jede der genannten Haltevorrichtungen mindestens einen Nachteil bei der Verwendung in Vakuum aufweist.

Effekte der Elektrostatik werden seit langer Zeit in der Technik insbesondere zur Befestigung von relativ kleinen und leichten Werkstücken verwendet. Dabei kommen die Coulomb'sche Wechselwirkung oder der Johnsen-Rahbek-Effekt (vgl. US 1,533,757) zur Verwendung. Wie bekannt werden Materialeigenschaften von Isolatoren, Leitern und Halbleitern sowie elektrische Ladungen dazu verwendet, Kräfte, insbesondere Haltekräfte, zu erzeugen, ohne dass dabei elektrische Ladungen "fließen".

Zur Werkstückbefestigung wird die elektrostatische Haltekraft beispielsweise in der Drucktechnik oder beim Plotten von kleineren Bögen benutzt; ebenfalls können Trommelschreiber mit elektrostatischer Medienbefestigung (Papier) als bekannter Stand der Technik angesehen werden.

In der Halbleiterindustrie, insbesondere Substratbearbeitung in Vakuum, bevorzugt Hoch- oder Ultrahochvakuumanlagen, ist es üblich, Substrate mittels einfachen elektrostatischen Substrathalterungen zu befestigen. Derartige Substrathalterungen werden beispielsweise in Ionenimplantierungsanlagen verwendet. Solche Anlagen können das Substrat oder die Substrate unter bestimmten Winkeln rotieren, vgl. US2014/0290862 A1. Des Weiteren kann ein Translationsfreiheitsgrad ebenfalls als Erweiterung einer Substrathalterung betrachtet werden, vgl. US2015/0170952A1. Das Lösen der Substrate von den Halterungen ist bereits einschlägig untersucht, vgl. DOI: 10.1585/pfr.3.051 sowie die Zusammenhänge des Substratmaterials mit der elektrostatischen Haltekraft, vgl. DOI: 10.1063/1.2778633

Der Stand der Technik offenbart also Substrathalterungen, welche mittels elektrostatischer Haltekräfte Substrate befestigen und bis zu drei Freiheitsgrade (zwei Achsen Kippung sowie eine Translation) ermöglichen.

Für die Erzeugung der elektrostatischen Haltekräfte im Stand der Technik werden Elektroden eingesetzt, welche auf der Oberfläche des Substrathalters oder im Volumen des Substrathalters unterbracht sind und dementsprechend alle Bewegungen, die das Substrat bei der Bearbeitung ausgesetzt ist, mit durchführen. Für die Kontaktierung jener Elektroden werden Schleifkontakte eingesetzt.

Mit den Anlagen des Stands der Technik sind jedoch die ausführbaren Bewegungsabläufe begrenzt. Die gehaltenen Substrate werden in den bekannten Substrathalterungen elektrostatisch gehalten. Sie ermöglichen jedoch keine vollständige wiederholbare Rotation, welche ohne Abgabe von Partikeln ablaufen könnte, da die Kontaktierung der elektrostatischen Haltefläche mittels Schleifkontakte ausgeführt wird. Diese erzeugen immer Partikelabrieb, der insbesondere für Hochvakuumanlagen oder Plasmaanlagen nachteilig wirkt.

Es ist daher die Aufgabe der vorliegenden Erfindung, eine verbesserte elektrostatische Substrathalterung zu Verfügung zu stellen. Insbesondere soll der unerwünschte Partikelabrieb während der Rotation minimiert bzw. sogar verhindert werden. Außerdem soll die Beweglichkeit des Halters verbessert werden.

Diese Aufgabe wird mit dem Gegenstand der nebengeordneten Patentansprüche gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei den angegebenen Wertebereichen sollen auch innerhalb der genannten Grenzen liegende Werte als Grenzwerte offenbart und in beliebiger Kombination beanspruchbar sein.

Eine erfindungsgemäße elektrostatische Substrathalterung (im Folgenden auch Probenhalter oder Haltevorrichtung genannt) zur Aufnahme und Halterung eines Substrats weist auf:
- einen Rotor, aufweisend einen Halter mit einer Haltefläche zur Fixierung des Substrats auf der Haltefläche (im folgenden auch Fixierfläche oder Fixieroberfläche genannt),
- einen Stator zur Aufnahme und Lagerung des Rotors,
- Elektroden zur Erzeugung einer elektrostatischen Haltekraft zur Fixierung des Substrats,
wobei der Stator die Elektroden aufweist.

Die erfindungsgemäßen Ausführungsformen der Haltevorrichtung können jedes Substrat, unabhängig von dessen Durchmesser, handhaben.

Die Erfindung betrifft weiterhin ein Verfahren zur Bearbeitung eines Substrats, wobei das Substrat durch eine erfindungsgemäße elektrostatische Substrathalterung gehalten und rotiert wird. Alle erfindungsgemäßen Aspekte der Substrathalterung gelten also auch für das Verfahren.

Die Erfindung betrifft weiterhin eine Bearbeitungsanlage, aufweisend eine Bearbeitungseinrichtung zur Bearbeitung eines Substrats und eine erfindungsgemäße elektrostatische Substrathalterung zur Halterung des Substrats. Alle erfindungsgemäßen Aspekte der Substrathalterung gelten also auch für die Bearbeitungsanlage.

Die Erfindung besteht insbesondere darin, dass die Elektroden sich nicht an der Haltefläche, sondern am und/oder im Stator befinden.

Der Vorteil der Erfindung besteht insbesondere darin, dass die erfindungsgemäße elektrostatische Substrathalterung ohne Schleifkontakte ausgeführt werden kann. Dadurch wird unerwünschter Partikelabrieb während der Rotation minimiert bzw. sogar verhindert, was insbesondere für Hochvakuumanlagen oder Plasmaanlagen vorteilhaft ist.

Die Partikelanzahl in einer Prozesskammer, in der sich der Probenhalter befindet, wird erheblich reduziert; dieses hält die Oberfläche des fixierten Substrats bzw. des erfindungsgemäßen Probenhalters rein.

Die erfindungsgemäße elektrostatische Substrathalterung entkoppelt die elektrostatische Halteeigenschaft vom mechanischen Bewegungsapparat, sodass durch den Verzicht auf Schleifkontakte der Elektrostatik der Substrathalterung ein reduzierter, bevorzugt minimaler, Partikelausstoß generiert wird.

Des Weiteren wird eine weitere und zusätzliche Kontamination des Probenhalters durch eine mehr oder weniger abgekapselte Bauweise vermieden oder zumindest stark reduziert.

Vorteile der Erfindung sind die reduzierte ausgestoßene Partikelmenge durch die Vermeidung schleifender Teile und eine Erweiterung der ausführbaren, reproduzierbaren Bewegungsabläufe.

Der Stator beinhaltet auch den als elektrostatische oder elektrische Baugruppe genannten Teil. Der Rotor beinhaltet auch den als mechanische Baugruppe bezeichneten Teil. Die erfindungsgemäße Aufgabe des Festhaltens und Bewegens des Substrats wird durch die Synergieeffekte und Zusammenarbeiten des Stators und Rotors, also das Zusammenwirken der mechanischen Baugruppe und der elektrostatischen Baugruppe gelöst.

Die vorliegende Erfindung betrifft eine elektrostatische Substrathalterung mit einem rotierbaren Halter und stehenden, nicht mitrotierten Elektroden.

Primär findet die erfindungsgemäße elektrostatische Substrathalterung Einsatz in Vakuum-, Hochvakuum- und/oder Ultrahochvakuumanlagen mit hohen Anforderungen an Reinheit sowie Partikelfreiheit.

Es sollen folgende Festlegungen getroffen werden: Die Z-Richtung bzw. Z-Achse verläuft senkrecht bzw. als Flächennormale zur Haltefläche. Die X-, Y-Richtungen bzw. Achsen verlaufen senkrecht zueinander und parallel zur bzw. in der Haltefläche des Halters.

Eine Rotation um die x-Achse wird mit ρ, eine Rotation um die y-Achse wird mit ϑ und eine Rotation um die z-Achse wird mit ϕ bezeichnet.

In einer bevorzugten Ausführungsform ist der Rotor durch elektrisch leitfähige Lagerelemente, insbesondere Kugellager und/oder Rillenkugellager und/oder Schrägkugellager und/oder Tonnenlager und/oder Axiallager und/oder Radiaxlager, gelagert. Durch die elektrische Leitfähigkeit kann insbesondere vorteilhaft die elektrostatische Kraft besonders effizient auf das Substrat ausgeübt werden.

In einer anderen bevorzugten Ausführungsform ist es vorgesehen, dass die elektrisch leitfähigen Lagerelemente die Elektroden des Stators berühren. Dadurch kann insbesondere vorteilhaft die elektrostatische Kraft besonders effizient auf das Substrat ausgeübt werden.

In einer anderen bevorzugten Ausführungsform ist es vorgesehen, dass die Dicke des Halters in Z-Richtung weniger als 100 mm, bevorzugt weniger als 50 mm, besonders bevorzugt weniger als 10 mm, ganz besonders bevorzugt weniger als 5 mm beträgt. Dadurch kann der Abstand zwischen den Elektroden und der Haltefläche verkleinert werden, sodass die Haltekraft optimiert wird.

In einer anderen bevorzugten Ausführungsform ist es vorgesehen, dass der Abstand zwischen den Elektroden und der Haltefläche weniger als 100 mm, bevorzugt weniger als 50 mm, besonders bevorzugt weniger als 10 mm, ganz besonders bevorzugt weniger als 5 mm beträgt. In einer anderen Ausführungsform beträgt der Abstand zwischen den Elektroden und der Haltefläche weniger als 3 mm, bevorzugt weniger als 1 mm, besonders bevorzugt weniger als 100 Mikrometer beträgt. Mit einem derart geringen Abstand kann die Haltekraft weiter verbessert werden.

In einer anderen bevorzugten Ausführungsform ist es vorgesehen, dass auf der dem Substrat abgewandten Seite des Halters Vertiefungen angeordnet sind, in denen die Elektroden angeordnet sind, wobei die Vertiefungen insbesondere konzentrisch und/oder als Kanäle ausgebildet sind. Dadurch kann der Abstand zwischen den Elektroden und der Haltefläche verringert werden. Außerdem können die Elektroden optimal verteilt werden, um eine gewünschte und insbesondere gleichmäßig verteilte Haltekraft zu erzeugen.

In einer anderen bevorzugten Ausführungsform ist es vorgesehen, dass die Elektroden als Ringe ausgebildet sind, insbesondere sind die Ringe äquidistant und/oder konzentrisch angeordnet. So können vorteilhaft die Elektroden optimal verteilt werden, um eine gewünschte und insbesondere gleichmäßig verteilte Haltekraft zu erzeugen.

In einer anderen bevorzugten Ausführungsform ist es vorgesehen, dass die Elektroden als Kreissektoren und/oder Kreisringsektoren ausgebildet sind. So können vorteilhaft die Elektroden optimal verteilt werden, um eine gewünschte und insbesondere gleichmäßig verteilte Haltekraft zu erzeugen.

In einer anderen bevorzugten Ausführungsform ist es vorgesehen, dass der Halter als Wabenstruktur ausgebildet ist. Dadurch kann die Erzeugung der Haltekraft noch weiter verbessert werden.

In einer anderen bevorzugten Ausführungsform weist die Substrathalterung ein Positionier-, Halte- und Bewegungssystem zur Bewegung des Substrats und/oder des Halters auf. Dies erleichtert vorteilhaft die Durchführung der Bewegungen des Substrats und/oder des Halters.

In einer anderen bevorzugten Ausführungsform ist es vorgesehen, dass das Substrat und/oder der Halter in mindestens drei Freiheitsgraden beweglich ist, bevorzugt in mindestens vier Freiheitsgraden, bevorzugter in mindestens fünf Freiheitsgraden, am bevorzugtesten in allen sechs Freiheitsgraden. Dies ermöglicht eine verbesserte Beweglichkeit des Substrats und/oder des Halters.

In einer anderen bevorzugten Ausführungsform ist es vorgesehen, dass das Positionier-, Halte- und Bewegungssystem für mindestens einen Freiheitsgrad mit einem Grobantrieb und einem Feinantrieb ausgebildet ist. Dieser ermöglicht vorteilhaft die exakte Einstellung der Bewegungen.

In einer anderen bevorzugten Ausführungsform ist es vorgesehen, dass die Antriebe des Positionier-, Halte- und Bewegungssystems derart ausgelegt sind, dass sie in einem nicht bewegten Zustand ohne Betriebsspannung und/oder Strom und/oder andere Energiezufuhr die jeweilige Position beibehalten und/oder arretieren können. Dies ermöglicht vorteilhaft das Festhalten des Substrats und/oder Halters in einer definierten Position.

In einer anderen bevorzugten Ausführungsform ist es vorgesehen, dass die Substrathalterung eine zentrale Steuereinheit und/oder Regeleinheit zur Steuerung und/oder Regelung von Bewegungen und/oder Abläufen, insbesondere der Fixierung des Substrates, der Position des Halters, der Geschwindigkeiten und/oder der Beschleunigungen des Halters aufweist. Dies ermöglicht vorteilhaft eine verbesserte Einstellung der gewünschten Parameter.

In einer anderen bevorzugten Ausführungsform ist es vorgesehen, dass die Substrathalterung mindestens einen Sensor zur Messung von Einflussfaktoren, insbesondere ein Abstands- und/oder Positionssensor, und mindestens einen Aktor zur Steuerung und/oder Regelung in Abhängigkeit der gemessenen Einflussfaktoren, insbesondere ein Positionsgeber und/oder Winkelgeber aufweist. Dies ermöglicht vorteilhaft, dass in einer Regelschleife eine Überprüfung der Einflussfaktoren und eine optimale Einstellung der Bewegungen erfolgen kann.

Die erfindungsgemäße Substrathalterung verfügt über mindestens drei, am bevorzugtesten mindestens vier, am aller bevorzugtesten mindestens fünf Bewegungsfreiheitsgrade.

Die erfindungsgemäße Substrathalterung erlaubt 360°-Rotationen um die drei Rotationsachsen. Die Elektroden werden erfindungsgemäß nicht rotiert. Es werden also die Bewegungen um die drei Rotationsachsen jeweils von den elektrischen und/oder elektronischen Funktionen entkoppelt.

Dadurch, dass keine Kabel zur Stromversorgung in den Halter führen, kann der Halter in alle Richtungen bewegt und/oder um alle Achsen rotiert werden.

Durch die erfindungsgemäße Trennung zwischen elektrostatischen und mechanischen Funktionen gibt es wenige bis gar keine Doppelfunktionen elektrostatischer und mechanischer Natur: elektrostatische Bauteile übernehmen elektrostatische Funktionen wie Ladungstransport oder Isolation sowie die elektrostatische Krafterzeugung, wobei ausschließlich die Haltefläche der Substrathalterung über die Ladungstrennung elektrostatisch geladen wird. Mechanisch beanspruchte Teile wie Antriebe oder Führungen oder Lager können weitgehend frei vom geschalteten elektrischen Potential sein. Die Stützfunktion der Haltefläche bildet eine Mischform, da durch die elektrostatische Kraft die Funktionalität erzeugt wird.

Durch die Funktionstrennung wird eine Vereinfachung der Konstruktion sowie der Fertigungsaufwand der Bauteile sowie Baugruppen erreicht, was sich positiv auf die Kostenstruktur der Substrathalterung und/oder der Gesamtanlage auswirkt.

Bei dem Substrat handelt es sich mit Vorzug um einen Wafer, insbesondere einen Halbleiterwafer. Wafer sind genormte Substrate mit wohl definierten, standardisierten Durchmessern. Sie können allerdings im Allgemeinen jede beliebige Form besitzen. Die Durchmesser können im Allgemeinen jede beliebige Größe annehmen, besitzen aber meistens eine der genormten Durchmesser von 1 Zoll, 2 Zoll, 3 Zoll, 4 Zoll, 5 Zoll, 6 Zoll, 8 Zoll, 12 Zoll und 18 Zoll bzw. 25.4 mm, 50.8 mm, 76.2 mm, 100 mm, 125 mm, 150 mm, 200 mm, 300 mm, 450 mm oder größer.

Im weiteren Verlauf der Beschreibung wird allgemein von Substraten gesprochen. Insbesondere beziehen sich die erfindungsgemäßen Ausführungsformen allerdings vorwiegend auf Wafer, insbesondere Halbleiterwafer.

### Erfindungsgemäße Substrathalterung

Die vorliegende Erfindung betrifft eine elektrostatische Substrathalterung, welche einen rotierbaren Halter und stehende, d.h. nicht mitrotierte Elektroden aufweist.

Die Elektroden können verallgemeinert als elektrostatische Baugruppe und der Halter als mechanische Baugruppe aufgefasst werden.

Erfindungsgemäß wird die elektrostatische Baugruppe weitestgehend, insbesondere vollständig, von der mechanischen Baugruppe entkoppelt.

Die erfindungsgemäße elektrostatische Substrathalterung entkoppelt die elektrostatische Halteeigenschaft vom mechanischen Bewegungsapparat. Mit anderen Worten: die Funktionen der elektrostatischen Baugruppe sind von der mechanischen Baugruppe weitgehend, insbesondere vollständig, voneinander getrennt.

Für eine erfindungsgemäße Substrathalterung, welche insbesondere in einer Bearbeitungsanlage, insbesondere eine Hoch- und/oder Ultrahochvakuumanlage, verwendet wird, wird der Effekt der Elektrostatik zur Haltekrafterzeugung verwendet.

Zwei Effekte der Elektrostatik sind von besonderer Bedeutung: der Johnsen-Rahbek-Effekt und der Coulomb-Effekt.

Mittels einem der genannten Effekte der Elektrostatik wird das Substrat auf einer definierten Stelle der erfindungsgemäßen Substrathalterung, der sogenannten Haltefläche, befestigt. Die Haltefläche ist eine zur Substratbefestigung ausgebildete, bevorzugt plan (eben) ausgeführte, Fläche eines Halters, welcher als Bauteil in der Substrathalterung eingebaut ist.

Im weiteren Verlauf wird die Ebenheit als Maß für die Perfektion einer planen Fläche, insbesondere einer Oberfläche, verwendet. Abweichungen von einer planen Oberfläche ergeben sich durch mikroskopische und/oder makroskopische Fehler von einer mathematisch idealen Ebene.

Diese Fehler lassen sich auch als Welligkeiten und Rauigkeiten definieren. Die Welligkeit einer Oberfläche zeichnet sich durch eine gewisse periodische Anhebung und Absenkung der Oberfläche, insbesondere im Millimeterbereich, seltener im Mikrometerbereich aus. Rauigkeit hingegen ist ein eher aperiodisches Phänomen im Mikro- bzw. Nanometerbereich.

Die genaue Definition derartiger Oberflächeneigenschaften ist jedem Fachmann der Oberflächenphysik-, Tribologie, des Maschinenbaus oder der Werkstoffwissenschaften bekannt.

Um die unterschiedlichen Abweichungen von der idealen Oberfläche zu behandeln, kann im weiteren Verlauf der Beschreibung der Begriff der Rauheit synonym für die Überlagerung aller derartigen Effekte verwendet werden. Die Rauheit wird entweder als mittlere Rauheit, quadratische Rauheit oder als gemittelte Rauhtiefe angegeben.

Die ermittelten Werte für die mittlere Rauheit, die quadratische Rauheit und die gemittelte Rauhtiefe unterscheiden sich im Allgemeinen für dieselbe Messstrecke bzw. Messfläche, liegen aber im gleichen Größenordnungsbereich. Daher sind die folgenden Zahlenwertebereiche für die Rauheit entweder als Werte für die mittlere Rauheit, die quadratische Rauheit oder für die gemittelte Rauhtiefe zu verstehen.

Die Rauheit ist dabei kleiner als 100 µm, vorzugsweise kleiner als 10 µm, noch bevorzugter kleiner als 1 µm, am bevorzugtesten kleiner als 100nm, am allerbevorzugtesten kleiner als 10nm.

Für die Ebenheit als makroskopische Größe gelten die für die Rauheit aufgeführten Werte und Parameter in Analogie zu DIN ISO 2768-2, Toleranzklasse H und besser.

Im Weiteren wird auf zwei physikalische Effekte der Elektrostatik näher eingegangen, die wichtig für das Verständnis der erfindungsgemäßen Ausführungsformen sind.

### Krafterzeugung mittels Coulomb-Effekt/Johnsen-Rahbek-Effekt

Durch das Anlegen einer Potentialdifferenz zwischen zwei Elektroden entstehen an deren Oberflächen gegenpolige Aufladungen. Zwischen den aufgeladenen Oberflächen baut sich ein elektrisches Feld auf.

Bei der elektrostatischen Substrathalterung werden die Elektroden insbesondere parallel nebeneinandergelegt, sodass das elektrische Feld in einem Bogen von der einen Elektrode zur anderen Elektrode aufgebaut wird. Kommt ein Substrat mit diesem elektrischen Feld in Berührung, werden an der Substratoberfläche Ladungen beeinflusst und/oder durch Orientierungspolarisation orientiert.

In jedem Fall wird die einer Elektrode zugewandte Substratoberfläche gegenpolig geladen. Durch die gegenpolige Ladung an der Substratoberfläche und der Elektrode ziehen sich beide an.

Befinden sich die Elektroden in oder unterhalb des Halters, so durchströmt das von den Elektroden erzeugte elektrische Feld auch den Halter. Ist der Halter als Dielektrikum ausgeführt, kann es im Halter zu keinem Ladungsfluss kommen.

Der Halter kann daher abhängig von seiner relativen Dielektrizitätskonstante eine entsprechende Oberflächenpolarisation an der Haltefläche hervorrufen, welche dann als die eigentliche Quelle für die Polarisation der Substratoberfläche angesehen werden kann.

Als Werkstoffe des Halters können elektrische Isolatoren wie SiO2 und/oder nichtleitende Keramiken mit Vorzug verwendet werden. Es sind weitere, insbesondere hoch- oder ultrahochvakuumtaugliche, Werkstoffe wie Gläser, Glaskeramiken, Karbide, Nitride und/oder sonstige Dielektrika möglich.

Die Besonderheit der Erfindung liegt in der Ausstattung der elektrostatischen Substrathalterung mit nicht mitrotierten Elektroden, welche von der Haltefläche beabstandet und ohne galvanischen Kontakt dazu ausgeführt sind, und im elektrisch isolierenden mechanischen Aufbau. Hierdurch werden die bewegten mechanischen Teile vollständig von den elektrostatischen Baugruppen, welche für die Haltekrafterzeugung relevant sind, galvanisch und örtlich entkoppelt.

Ein anderer Effekt ist der Johnsen-Rahbek Effekt. Der Effekt nützt den schwach leitfähigen Halter aus, der ebenfalls vom elektrischen Feld der Elektroden durchströmt wird. Durch die schwache Leitfähigkeit des Halters entsteht durch das elektrische Feld allerdings keine Orientierungspolarisation, sondern ein Ladungsfluss an die Oberfläche.

Diese Ladungen können dann als die eigentliche Quelle für die Polarisation der Substratoberfläche angesehen werden. Bei der Kontaktierung mit einem anderen Dielektrikum entstehen in Folge der Unebenheiten der Oberflächen der beiden kontaktierenden Objekte kleine Lücken, zwischen denen sehr große Feldstärken erzeugt werden können.

Die dadurch erzeugte, große, Kraft wird als Johnsen-Rahbek-Kraft bezeichnet und führt ebenfalls zu einer Anziehung zwischen dem Substrat und dem Halter. Wird die Haltekraft mit dem Johnsen-Rahbek-Effekt erzeugt, kann der Halter als schwacher elektrischer Leiter insbesondere induzierte Ladungen des Substrats ableiten.

Dabei wird die elektrisch schwach leitende Haltefläche (i.e. der Halter) mit den elektrostatischen Baugruppen elektrisch leitend kontaktiert. Diese elektrostatische Kontaktierung des Halters kann an einer von dem zu haltenden Substrat abgewandten Seite erfolgen. Die unterschiedlichen Ausführungsformen der Substrathalterung mit Johnsen-Rahbek-Kraft als Haltekraft werden an späterer Stelle detailliert behandelt.

### Mechanische Baugruppe, unabhängige Freiheitsgrade

In einer anderen bevorzugten Ausführungsform weist die elektrostatische Substrathalterung ein Positionier-, Halte- und Bewegungssystem zur Bewegung des Substrats und/oder des Halters auf.

In einer anderen bevorzugten Ausführungsform ist das Substrat und/oder der Halter in mindestens drei Freiheitsgraden beweglich, bevorzugt in mindestens vier Freiheitsgraden, bevorzugter in mindestens fünf Freiheitsgraden, am bevorzugtesten in allen sechs Freiheitsgraden.

Insbesondere unabhängig von der erfindungsgemäßen Ausführungsform der elektrostatischen Haltekrafterzeugung der Substrathalterung kann für die Durchführung der geforderten Bewegungsabläufe der Bearbeitung des Substrats, für welche die Substrathalterung eingesetzt wird, das mechanische Positionier-, Halte- und Bewegungssystem für alle sechs unabhängigen Freiheitsgrade des Substrats verwendet werden. Eine mögliche Unterteilung ist wie folgt:
Es können erfindungsgemäß bis zu fünf Bewegungsfreiheitsgrade, welche bei der Bearbeitung eines Substrats die erfindungsgemäßen Bewegungen durchführen, verwendet werden. Der sechste Freiheitsgrad wird mittels der Substrathalterung insbesondere elektrostatisch blockiert, sodass das Substrat nicht unabhängig von der Substrathalterung bewegt wird. Dieser sechste Freiheitsgrad kann insbesondere beim Be- und/oder Entladen des Substrats ausgeführt werden.

In einer anderen bevorzugten Ausführungsform ist das Positionier-, Halte- und Bewegungssystem für mindestens einen Freiheitsgrad mit einem Grobantrieb und einem Feinantrieb ausgebildet.

Es können insbesondere zusammengesetzte Bewegungssysteme für einen Freiheitsgrad (Translation oder Rotation) verwendet werden. Ein zusammengesetztes Bewegungssystem führt die Bewegung eines Freiheitsgrades als mehrere Einheiten aus. Beispielsweise kann ein Grobantrieb und eine Führung in einer Translationsrichtung sowie ein Feinantrieb und eine Führung in derselben als zusammengesetzter Antrieb für einen Freiheitsgrad verstanden werden.

In einer anderen bevorzugten Ausführungsform sind die Antriebe (Grob- und/oder Feinantriebe) des Positionier-, Halte- und Bewegungssystems so ausgelegt, dass sie in einem nicht bewegten Zustand ohne Betriebsspannung und/oder Strom und/oder andere Energiezufuhr die jeweilige Position beibehalten und/oder arretieren können. Mit anderen Worten werden bevorzugt selbsthaltende Antriebe mitsamt Führungen und/oder Lager verwendet.

Der besondere Vorteil liegt in der geringeren Hitzeentwicklung ohne Bewegung und somit Vermeidung von parasitären Wärmequellen, welche das thermische Management insbesondere im Vakuum oder Hochvakuum oder Ultrahochvakuum erschweren.

Erfindungsgemäß ist es insbesondere möglich, dass die Substrathalterung vier oder weniger Freiheitsgrade des Substrates ausführt; dann soll zielgerichtet die Anlage die fehlenden Freiheitsgrade ausführen.

Für die Definition der Freiheitsgrade sowie Raumrichtungen wird vorzugsweise ein kartesisches Koordinatensystem eingeführt. Der Ursprung des Koordinatensystems wird vorzugsweise in den Mittelpunkt der Haltefläche des Halters der Substrathalterung gelegt, und wird als fest und unbeweglich definiert.

Bei Bewegungen des Halters sowie der gesamten Substrathalterung wird also das Koordinatensystem nicht mitbewegt und/oder mitrotiert. Der Mittelpunkt wird bei hochsymmetrischen Halteflächen als geometrischer Mittelpunkt, bei nicht hochsymmetrischen Halteflächen als Schwerpunkt verstanden.

Wie bereits oben festgelegt, verlaufen die x-Richtung bzw. x-Achse und die y-Richtung bzw. y-Achse auf der Haltefläche, die z-Richtung bzw. z-Achse ist als Flächennormale zur Haltefläche definiert. Es ist insbesondere möglich, den Ursprung des Koordinatensystems in jeden beliebigen Punkt der Anlage zu transformieren oder weitere Koordinatensysteme zu definieren.

Eine Rotation um die x-Achse wird als ρ, eine Rotation um die y-Achse wird als ϑ und eine Rotation um die z-Achse wird als ϕ bezeichnet.

In der vorliegenden Offenbarung werden die Bewegungsrichtungen allgemein verstanden, sodass die Rotations- und/oder Translationsrichtungen sowie Ursprünge der Bewegungen nicht auf die Koordinatenachsen fallen müssen, sondern durch mathematische Transformationen im Koordinatensystem beschrieben werden können; es wird auf eine detaillierte Beschreibung verzichtet, da dieses dem Fachmann bekannt ist.

Neben der Hauptfunktion der Substrathalterung, das Substrat festzuhalten, wird die Nebenfunktion, Bewegungsabläufe zu ermöglichen, ebenfalls als konstruktives Merkmal in die Substrathalterung integriert.

Um die geforderten Bewegungsabläufe um die mindestens drei, bevorzugt vier, besonders bevorzugt fünf Freiheitsgrade zu ermöglichen, werden hohe Anforderungen an die Genauigkeit der mechanischen, bewegbaren Bauteile gestellt. Es werden für den Zweck genaue, insbesondere spielfreie und/oder umkehrspielfreie, vorgespannte Lager und Führungen sowie Antriebe verwendet.

Die aufgeführten Freiheitsgrade werden insbesondere ab dem Substrat betrachtet.

### 1. Freiheitsgrad:

Für die Betrachtung der unabhängigen Freiheitsgrade ist es zweckmäßig, die Bewegungsrichtungen, also die Freiheitsgrade, ab dem Substrat bis zum nicht bewegten Gestell als eine Bewegungskette aufzufassen.

Die Bewegungskette ab dem Substrat betrachtet kann in einer ersten erfindungsgemäßen Ausführungsform eine Translation, also eine Linearbewegung erzeugen. Die Richtung dieser ersten Translation kann in z-Richtung durchgeführt werden. Dies kann technologisch für die Bestückung sowie Substratwechsel begründet durchgeführt werden.

Sollte nicht die Substrathalterung das Substrat anheben, sondern insbesondere durch Kantengreifer das Substrat von der Substrathalterung entfernt werden, kann dieser Freiheitsgrad der Substrathalterung der Anlage übertragen werden und entfällt für die Substrathalterung.

### 2. Freiheitsgrad:

Als nächste Bewegung des Substrats kann die Rotation um die z-Achse erfolgen. Die dazu notwendigen Lager, Antriebe sowie deren Ausführungsformen werden später aufgeführt.

### 1. und 2. Freiheitsgrad:

Decken die zur Substratbearbeitung notwendigen Bewegungen mehrere unabhängige Freiheitsgrade ab, können die Antriebe, Lager und/oder Führungen, die die Bewegung ausführen, in Modulbauweise aufgebaut und als Untergruppen der mechanischen Baugruppe verstanden werden. Die Module führen Bewegungen mit mehr als einem unabhängigen Freiheitsgrad aus. Es können also in einem Modul Translationen zusammengeführt werden, wie insbesondere bei Kreuztischen oder mindestens eine Translation und eine Rotation oder zwei Rotationen. Somit ist in einer weiteren erfindungsgemäßen Ausführungsform eine Kombination als Hub-Dreh-Modul oder Dreh-Hub-Modul möglich.

In einer anderen bevorzugten Ausführungsform besteht die Kombination des Dreh-Hub-Moduls aus einer rotierbaren, mit Öffnungen und/oder Löchern und/oder Langlöchern versehenen, Haltefläche des Halters der mechanischen Baugruppe der Substrathalterung und linear verfahrbaren Flächen, Pads und/oder Stiften zur Hebung und/oder Senkung des Substrats.

Die Anzahl der verfahrbaren Stifte und/oder Flächen beträgt in einer beispielhaften Ausführungsform mindestens 2, bevorzugt mindestens 3, besonders bevorzugt mindestens 4, ganz besonders bevorzugt mindestens 4.

### 3. Freiheitsgrad und/oder 4. Freiheitsgrad

Als dritter und/oder vierter Freiheitsgrad können Rotationen um die x-Achse und/oder die y-Achse durchgeführt werden. Dabei können die Rotationsachsen der jeweiligen Bewegung mit einer beliebigen Koordinatentransformation des Ursprungs verstanden werden.

Wenn die x- und/oder y-Achse auf die der Haltefläche abgewandten zu bearbeitende Oberfläche des Substrates fällt, kann eine Fehlertoleranz der Rotationen des dritten und/oder vierten unabhängigen Freiheitsgrades durch die Anwendung der Konstruktionsprinzipien Innozenz und Invarianz erreicht werden. Beide Konstruktionsprinzipien erzeugen eine mindestens fehlerarme (Innozenz), wenn nicht unter Umständen in sich fehlerfreie (Invarianz) funktionale Gruppe.

Durch eine innozente, fehlerarme Anordnung der Rotationsachsen, insbesondere durch eine kardanische Aufhängung und/oder ein Kugelkalottendesign, welche dem Fachmann bekannt sind, können Fehler erster Ordnung der Positionierung konstruktiv beseitigt werden. Mit anderen Worten führt dies zur Verringerung von Kippfehlern.

Kippfehler verursachen insbesondere beim Bedampfen, Besputtern und/oder bei einer Ionenbehandlung (Abtragen der Oberfläche, und/oder Amorphisierung und/oder Ionenimplantation) und/oder einer Radikalenbehandlung mit Plasma, Unregelmäßigkeiten und/oder Fehlproduktionen, was oft zur Aussonderung aus der Fertigungskette mit abschließender Überprüfung und Entsorgung des Substrates führt.

### 5. Freiheitsgrad und/oder 6. Freiheitsgrad

In einer anderen bevorzugten erfindungsgemäßen Ausführungsform der Substrathalterung wird eine exakte Positionierbarkeit und Bewegbarkeit der Substrathalterung entlang der Koordinatenachsenrichtungen x und/oder y gewährleistet.

Falls keine Aufteilung der Relativbewegungen des Systems aus Bearbeitungseinrichtung und Substrathalterung erfolgt ist, wird das auf der Haltefläche befestigte Substrat insbesondere rezeptgesteuert und/oder rezeptgeregelt bewegt.

### Mechanische Baugruppe

Eine erfindungsgemäße Bearbeitungsanlage weist auf mindestens eine Bearbeitungseinrichtung zur Bearbeitung des Substrats, welches durch die Substrathalterung festgehalten wird.

Sind Bewegungen zur Bearbeitung und/oder zum Handling notwendig, können die erforderlichen unabhängigen Freiheitsgrade von der Bearbeitungseinrichtung und/oder von der Substrathalterung durchgeführt werden. So ist vorteilhaft eine Aufteilung der unabhängigen Freiheitsgrade zwischen der Bearbeitungseinrichtung und der Substrathalterung möglich.

In einer beispielhaften bevorzugten erfindungsgemäßen Ausführungsform kann die Bearbeitungseinrichtung durch Kippen und/oder Gieren, also Verstellung der Winkellage, eingestellt werden, wodurch Bewegung als Translationen insbesondere einer Bearbeitungsstrahlung auf dem Substrat resultieren.

In einer anderen, besonders bevorzugten, erfindungsgemäßen Ausführungsform sind die sechs Freiheitsgrade des Substrats in Bezug zur Bearbeitungseinrichtung so aufgeteilt, dass die Substrathalterung eine Translation, insbesondere in x-Richtung, sowie eine Rotation um die y-Achse und eine Rotation um die z-Achse ausführen kann. Die weiteren Freiheitsgrade werden durch in die Anlage integrierte Handlingroboter und/oder Greifer und/oder Handlingvorrichtungen und/oder die Bewegungen der Bearbeitungsquelle übernommen.

In einer anderen bevorzugten Ausführungsform sind die sechs Freiheitsgrade des Substrats im Bezug zur Bearbeitungseinrichtung so aufgeteilt, dass die Substrathalterung eine Translation, insbesondere in der x-Richtung, eine weitere Translation, insbesondere in der z-Richtung zur Höhenjustierung des Substrates auf der Haltefläche, sowie eine Rotation um die y-Achse und eine Rotation um die z-Achse ausführen kann.

In einer anderen bevorzugten Ausführungsform sind die sechs Freiheitsgrade des Substrats im Bezug zur Bearbeitungseinrichtung so aufgeteilt, dass die Substrathalterung zwei Translationen, insbesondere in der x-Richtung und in der y-Richtung, und eine weitere Translation, insbesondere in der z-Richtung zur Höhenjustierung des Substrates auf der Haltefläche, und eine Rotation um die y-Achse und eine Rotation um die z-Achse ausführen kann.

Erfindungsgemäß soll die Translationsbewegung in x-Richtung und/oder in y-Richtung einen Verfahrweg größer 100 mm, bevorzugt größer 150 mm, besonders bevorzugt größer 300 mm, ganz besonders bevorzugt größer 450 mm abdecken.

Die Wegangaben können auch +/- halbe Strecke, bspw. +/- 50 mm umfassen.

Für die Translation in z-Richtung soll ein Verfahrweg größer 5 mm, bevorzugt größer 10 mm, besonders bevorzugt größer 30 mm möglich sein.

Die Positioniergenauigkeit der Translationen soll kleiner 5mm, bevorzugt kleiner 1 mm, besonders bevorzugt kleiner 0,1 mm, ganz besonders bevorzugt kleiner 0,01 mm, im optimalen Fall kleiner 50 Mikrometer, im Idealfall kleiner 50 nm erreichen.

Für die Rotationen ϑ und/oder p sollen Kippwinkel kleiner 181 Grad, bevorzugt kleiner 91 Grad, besonders bevorzugt kleiner 61 Grad, im optimalen Fall kleiner 31 Grad, im Idealfall kleiner 21 Grad frei einstellbar sein.

Die Winkelangaben können auch +/- halbe Winkelangabe, bspw. +/-90,5 Grad umfassen.

Der Kippfehler für die Rotationen ϑ und/oder ρ und/oder ϕ soll (als Abstand am jeweiligen Rand bzw. Durchmesser der Haltefläche als eine Kipphöhe ausgedrückt) weniger als 5 mm, bevorzugt weniger als 2 mm, besonders bevorzugt weniger als 1 mm, ganz besonders bevorzugt weniger als 0,1 mm, im optimalen Fall weniger als 0,01 mm, im Idealfall weniger als 0,001 mm betragen. Anders formuliert ist der angegebene Abstand ein Abstand zur nominell bzw. ideal zu erreichenden Position.

Für die Rotation ϕ sollen gleich- oder wechselsinnige Rotationen größer 360 Grad möglich sein.

### Steuerung/Regelung

Gemäß einer anderen bevorzugten Ausführungsform ist eine zentrale Steuereinheit und/oder Regeleinheit angeordnet zur Steuerung und/oder Regelung von Bewegungen und/oder Abläufen, insbesondere der Fixierung des Substrates, der Position des Halters, der Geschwindigkeiten und/oder der Beschleunigungen des Halters.

Die Steuerung und/oder Regelung der Bewegungen und/oder Abläufe, insbesondere die Fixierung des Substrates, die Position der Substrathalterung mit dem Substrat in der Anlage, die Geschwindigkeiten und/oder die Beschleunigungen, erfolgt mit Vorzug über die zentrale Steuereinheit und/oder Regeleinheit, insbesondere einen Computer mit einer Steuerungssoftware und/oder Regelungssoftware.

Die (widerkehrenden) Steuerungs- und/oder Regelungsabläufe können als Rezepte zusammengefasst, insbesondere als maschinenlesbare Code, vorliegen. Rezepte sind optimierte Wertesammlungen von Parametern, die im funktionalen und/oder verfahrenstechnischen Zusammenhang stehen. Die Nutzung von Rezepten erlaubt es, eine Reproduzierbarkeit von Produktionsabläufen zu gewährleisten.

Gemäß einer anderen bevorzugten Ausführungsform ist mindestens ein Sensor zur Messung von Einflussfaktoren und mindestens ein Aktor zur Steuerung und/oder Regelung in Abhängigkeit der gemessenen Einflussfaktoren angeordnet.

Für die Regelung und/oder Steuerung kann neben der Verwendung eines Wirkelementes (des Aktors) die Verwendung von entsprechenden Sensoren vorgesehen sein. Diese Sensoren werden insbesondere verwendet, um für eine Aufnahme und/oder Verarbeitung und/oder Weitergabe des zu messenden Einflussfaktors zu sorgen. Es können insbesondere Abstands- und/oder Positionssensoren (Positionsgeber und/oder Winkelgeber) und/oder elektrischer Strom und/oder elektrische Spannung als Regelgrößen verwendet werden.

Zur Bestimmung der Position der Substrathalterung in der Anlage können optische Mittel, und/oder induktive und/oder kapazitive und/oder faseroptische und/oder mechanische und/oder magnetische und/oder magnetostriktive Sensoren wie Weggeber, Laufzeitmessgeräte (Lasertriangulation) und/oder Interferometer verwendet werden.

Für die Bestimmung der Rotationen können die für die Längenmessung verwendeten, für die Rotation abgewandelten, Methoden wie Inkrementalgeber und/oder Absolutwertgeber verwendet werden.

Damit eine Rückkopplung über die elektrostatische Befestigung des Substrates erfolgt, können optische Mittel für eine Reflexionsmessung und/oder Kamerasysteme zur Kantendetektion und/oder Bildverarbeitung und/oder Drucksensoren Einsatz finden.

In einer weiteren Ausführungsform können die Veränderungen der elektrostatischen Größen beobachtet und entsprechend geregelt werden, um die Haltekraft aufrechtzuerhalten.

Bevorzugt soll die zu messende Größe eine Veränderung der insbesondere elektrischen Eigenschaften der Messgröße hervorrufen, sodass eine elektronische Erfassung, Weiterleitung und maschinelle, insbesondere rechnergestützte, Verarbeitung des Messergebnisses und/oder des Signals erfolgen kann.

### Lagerung des Rotors

In einer anderen bevorzugten Ausführungsform der Substrathalterung ist der Rotor durch elektrisch leitfähige Lagerelemente, insbesondere Kugellager und/oder Rillenkugellager und/oder Schrägkugellager und/oder Tonnenlager und/oder Axiallager, gelagert.

Es können handelsübliche Lager entsprechenden Durchmessers angewendet werden.

Die Lager und/oder Führungen können vorteilhaft insbesondere vakuum-, bevorzugt hochvakuum-, besonders bevorzugt ultrahochvakuumtauglich, ausgebildet sein.

In einer bevorzugten Ausführungsformen berühren die elektrisch leitfähigen Lagerelemente die Elektroden des Stators. Vorteilhaft erweitern die Lagerelemente so die Elektroden bis möglichst nahe an die der Haltefläche gegenüberliegende Seite des Halters.

Insbesondere können leitfähige Kugeln, die als Teil eines Kugellagers ausgebildet sind, die am Stator angebrachten Elektroden berühren.

Insbesondere sind Rillenkugellager und/oder Schrägkugellager und/oder Tonnenlager und/oder Axiallager anwendbar. In besonderen Fällen ist die Benutzung von einfachen zylindrischen Lagern denkbar, falls Abriebverhalten und Rollverhalten dies ermöglichen.

Erfindungsgemäß wird eine insbesondere konstante oder an einer Regelung oder Steuerung gekoppelte, variable Rotationsgeschwindigkeit größer 0,1 Umdrehungen/Minute (rpm), bevorzugt größer 1 rpm, besonders bevorzugt 10 rpm, ganz besonders bevorzugt größer 50 rpm, im Optimalfall größer 65 rpm, im Idealfall größer 100 rpm erzeugt. Es sind jedoch auch Rotationsgeschwindigkeiten kleiner 0,1 rpm und/oder ein Stillstand möglich.

Damit die Anlage, in der die Substrathalterung eingebaut ist, entsprechende Prozessergebnisse erzielen kann, ist nicht nur die Drehzahl der Rotation ϕ sondern auch die Winkelbeschleunigung von zentraler Bedeutung. Die Winkelbeschleunigung ist insbesondere für die Gleichmäßigkeit ein Kernparameter, da ein gleichmäßiger Zustand schneller erreicht werden kann. Insbesondere beträgt die Winkelbeschleunigung mehr als 1 rad/s2, bevorzugt mehr als 10 rad/s2, weiter bevorzugt mehr als 100 rad/s2, noch weiter bevorzugt mehr als 1000 rad/s2, besonders bevorzugt mehr als 10000 rad/s2.

Erfindungsgemäß kann eine insbesondere mehrachsige Rotation zur Positionierung von Substratzonen und/oder -bereichen in der Bearbeitungsanlage mittels der Substrathalterung durchgeführt werden. Für eine Positioniergenauigkeit ist eine gesteuerte und/oder eine geregelte Bewegung angeordnet, sodass eine beliebige Winkellage anfahrbar ist.

So soll insbesondere für eine gesteuerte Rotation um die z Achse eine volle 360° Rotation in 2^n Teile unterteilt werden. Insbesondere soll n größer 1, 2, 3, 4, 5, 6, 7, 8, 9, 10, 11, oder 12 sein. Somit kann ein entsprechend positionierungsbedingter Winkelfehler kleiner als 10 Grad, 5 Grad, 1 Grad, 0,1 Grad, 0,01 Grad erreicht werden.

In einer anderen bevorzugten Ausführungsform der Substrathalterung kann ein Radiaxlager, auch als Radial-Axiallager bekannt, eingesetzt werden. Durch die vielfache Überbestimmtheit des Rotationsverhaltens und/oder Einlauffähigkeit und/oder einstellbare Vorspannung der Lagerelemente und/oder Verwendung von (abrieboptimierten) Drahtkäfigen zur Spielbeseitigung und/oder Taumelfreiheit der Rotation sowie durch die freie Auslegbarkeit des Durchmessers des Lagers ist diese Ausführungsform besonders vorteilhaft.

So kann die elektrostatische Baugruppe eigenschaftenoptimiert, insbesondere haltekraftoptimiert und/oder abstandsoptimiert, insbesondere unterhalb des Substrates und des Halters angebracht werden.

### Gestaltung des Halters und Anordnungen elektrostatischer und mechanischer Baugruppen

Der Halter besitzt für die Funktion der Substrathalterung sowohl elektrostatisch als auch mechanisch eine Schlüsselrolle.

Der Halter ist Teil der mechanischen Baugruppe, da er auf der Haltefläche das Substrat mittels elektrostatischer Haltekraft geklemmt hält. Der Halter ist auch Teil der elektrostatischen Baugruppe, weil die elektrostatische Haltekraft durch den Halter das Substrat befestigt.

Erfindungsgemäß relevante Eigenschaften des Halters beinhalten die Eigenstabilität, die dielektrischen Eigenschaften, die Reinheit, thermische Ausdehnung, Wärmekapazität, Wärmeleitfähigkeit sowie die Korrosionsbeständigkeit.

Weiterhin ist die Anordnung (Positionen, Abstände, Orientierung) des Halters im Bezug zu den anderen Teilen der elektrostatischen Baugruppe sowie zur mechanischen Baugruppe von Bedeutung.

Erfindungsgemäß ist für die Substrathalterung vorteilhaft, den Abstand des Substrats zu den fest stehenden, nicht mitrotierten Elektroden zu minimieren; dadurch wird die elektrostatische Feldstärke entsprechend proportional reduziert. Vorteilhaft ist die minimierte elektrostatische Feldstärke für ein leichteres Ablösen des Substrats von der Substrathalterung, wodurch die Produktivität der Bearbeitungsanlage erhöht wird.

Soweit die Eigenstabilität der Haltefläche dies zulässt, beträgt die Dicke des Halters in z-Richtung bzw. senkrecht zur Haltefläche weniger als 100 mm, bevorzugt weniger als 50 mm, besonders bevorzugt weniger als 10 mm, im Idealfall weniger als 5 mm.

In einer anderen Ausführungsform der Haltefläche beträgt die Dicke des Halters in z-Richtung bzw. senkrecht zur Haltefläche weniger als 30% des Durchmessers des Halters, bevorzugt weniger als 10% des Durchmessers des Halters, besonders bevorzugt weniger als 5% des Durchmessers des Halters, ganz besonders bevorzugt weniger als 1% des Durchmessers des Halters, im Idealfall weniger als 0,5% des Durchmessers des Halters.

Die Dicke des Halters H bezieht sich auf einen Messpunkt an einer Elektrode. Der Halter kann aus technologischen Gründen in sich unterschiedlichen Dicken aufweisen. Der Halter kann auch als Platte mit nicht homogener Dicke ausgeführt sein, sodass Versteifungsoptimierte Auslegungsformen, insbesondere als Ergebnis von FEM-Analysen gekoppelter Felder für die Formgebung verwendet werden können. Insbesondere für die Eigenstabilität und/oder Funktionsintegration kann der Halter in z-Richtung technologisch bedingt insbesondere Randverstärkung aufweisen. Die Randverstärkung kann mehr als 1 mm, bevorzugt mehr als 4 mm, besonders bevorzugt mehr als 9 mm betragen. In bevorzugten Ausführungsformen kann es eine freie Spalthöhe zwischen den Elektroden und der nicht substratseitigen Oberfläche des Halters existieren.

In besonderen Ausführungsformen ist der Abstand zwischen den feststehenden, nicht mitrotierten Elektroden und der nicht substratseitigen Oberfläche des Halters kleiner 1mm, bevorzugt kleiner 500 Mikrometer, besonders bevorzugt kleiner 200 Mikrometer, im optimalen Fall kleiner 100 Mikrometer, im Idealfall kleiner 10 Mikrometer.

In einer weiteren bevorzugten Ausführungsform können auf der dem Substrat abgewandten Seite des Halters konzentrische Vertiefungen, insbesondere Kanäle ausgebildet sein, in welchen die Elektroden, insbesondere mit minimalem freien Abstand zum Halter, angeordnet sind, sodass der Abstand der elektrostatischen Elektroden zum Substrat minimiert werden kann. Somit kann in den Kanälen, zwischen der nicht substratseitigen Oberfläche des Halters und der Elektroden ein Abstand kleiner 1mm, bevorzugt kleiner 500 Mikrometer, besonders bevorzugt kleiner 200 Mikrometer, im optimalen Fall kleiner 100 Mikrometer, im Idealfall kleiner 10 Mikrometer bestehen.

Es ist in einer weiteren bevorzugten Ausführungsform vorgesehen, diesen nicht als monolithischen Block, sondern insbesondere als steifigkeitsoptimierte Wabenstruktur auszuführen. Die Haltefläche ist plan (eben) und vollflächig ausgeführt. Der Halter besitzt auf der der Haltefläche abgewandten Seite insbesondere in der Dicke verstärktes Material, welches streben- oder rippenartig so ausgeführt ist, dass es insbesondere sechseckige Wabenstrukturen ergibt. Somit kann die Höhe des Halters bei identischer mechanischer Steifigkeit reduziert werden. Dies ist für die dielektrischen Eigenschaften sowie für die verwendete elektrostatische Feldstärke bedeutend.

In einer weiteren bevorzugten Ausführungsform wird der Halter steifigkeitsoptimiert, insbesondere mit Wabenstrukturen ausgeführt, wobei die vom Substrat abgewandte Seite insbesondere mit unterschiedlich nivellierten Ebenen ausgeführt sein kann und wobei der Halter konzentrische Vertiefungen für die Aufnahme der Elektroden aufweist. Die dazu notwendigen Berechnungen können als Annäherung mittels "finite Elementen"-Methode (FEM) ausgeführt werden.

### Elektroden-Bauformen

In einer bevorzugten Ausführungsform sind die Elektroden als Ringe ausgebildet, insbesondere sind die Ringe äquidistant und/oder konzentrisch angeordnet.

In einer anderen bevorzugten Ausführungsform sind die Elektroden als Kreissektoren und/oder Kreisringsektor ausgebildet.

Bevorzugt sind die Elektroden voneinander galvanisch isoliert.

In einer weiteren bevorzugten Ausführungsform der Substrathalterung können die Elektroden voneinander galvanisch isoliert und von der Rotationsachse der Rotation ϕ insbesondere jeweils äquidistant als konzentrische Ringe ausgeführt werden.

Die Anzahl der Kreissektoren, -ringsektoren und/oder der Ringe sind in Abhängigkeit der Anzahl der Elektroden zu bestimmen. Die Elektroden gliedern sich als Quellen sowie als Senken für die elektrostatische Krafterzeugung. Somit soll es mindestens eine Quelle und mindestens eine Senke geben. Die Auslegung der Anzahl der Elektroden ist dem Fachmann der Elektrotechnik und Elektronik bekannt. Es gibt insbesondere mindestens zwei Elektroden, vorzugsweise mehr als 5 Elektroden, noch bevorzugter mehr als 10 Elektroden, am bevorzugtesten mehr als 20 Elektroden.

Für die Befestigung des Substrats auf der Haltefläche wird bevorzugt Gleichspannung an mindestens einem Elektrodenpaar angelegt. Die Spannung liegt zwischen 0,1 kV bis 10 kV, bevorzugt 0,4 kV bis 5 kV, besonders bevorzugt zwischen 0,5 kV bis 4 kV, ganz besonders bevorzugt zwischen 0,6 kV bis 3 kV.

In einer bevorzugten Ausführungsform wird die eingestellte elektrische Spannung zur Haltekrafterzeugung insbesondere geregelt gestellt, sodass eine Temperaturabhängigkeit der Haltekraft eingestellt werden kann. Somit wird ein Optimum der Haltekraft verwendet, welche sich aus den Parametern Temperaturverlauf, Haltekraft sowie elektrische Spannung ergibt.

Bei konstanter elektrischer Spannung wird die Haltekraft bei erhöhter Temperatur verstärkt, sodass das ein zerstörungsfreies Ablösen des Substrats von der Substrathalterung nicht mehr möglich ist.

Es wird vermutet, dass die elektrische Spannung zur Haltekrafterzeugung im Verlauf zur Temperaturerhöhung umgekehrt proportional verläuft. Für die exakte, geschlossene mathematische Beschreibung des Phänomens sind weitere Experimente notwendig.

Die elektrostatische Baugruppe kann aus einzelnen Elektroden bestehen. Für die Kontaktierung der einzelnen Elektroden kann insbesondere für den Johnsen-Rahbek-Effekt mindestens ein Rollelement verwendet werden, wobei pro Elektrode genau ein Rollelement, bevorzugt mehr als 1, bevorzugter mehr als 2, besonders bevorzugt mehr als 3, ganz besonders bevorzugt mehr als 4 Rollelemente verwendet werden.

Weiterhin können entweder unipolare Elektroden oder bipolare Elektroden verwendet werden.

Bevorzugt wird eine elektrostatische Baugruppe mit bipolar geschalteten Elektroden verwendet, wobei die Anzahl der Elektroden mehr als 1, bevorzugt mehr als 3, besonders bevorzugt mehr als 7, ganz besonders bevorzugt mehr als 14 ist.

Die Elektroden können bevorzugt einzeln, und/oder besonders bevorzugt paarweise, und/oder ganz besonders bevorzugt in Gruppen zusammengefasst geregelt und/oder gesteuert werden.

### Koppelung der elektrostatischen und der mechanischen Baugruppe der Substrathalterung, insbesondere mittels Johnsen-Rahbek-Effekt

Für die Erzeugung der elektrostatischen Haltekraft insbesondere mittels Johnsen-Rahbek-Effekt ist eine galvanische Kontaktierung der Elektroden mit dem schwach leitend ausgeführten dielektrischen Halter erforderlich.

Um die Nachteile des Standes der Technik auszubessern, wird auf die Schleifkontaktierung verzichtet.

Es werden elektrisch leitfähige und rollende Koppelelemente, auch Rollelemente genannt, eingesetzt. Die unterschiedlichen Ausführungsformen der Rollelemente können Kugeln, Tonnen, Rollen und/oder Nadeln beinhalten.

Durch eine Rollbewegung wird weniger Abrieb erzeugt als mit Rollbohren oder reinem Schleifen. Hat ein Rollelement als starrer Festkörper unterschiedliche Winkelgeschwindigkeiten (Tangentialgeschwindigkeiten), kann lediglich eine Stelle eine reine Rollbewegung ausüben. Andere Teile eines starren Festkörpers rotieren mit einer Mischform zwischen Rollen und Rutschen, welche Bewegung auch als Schleifen interprätierbar ist, ab. Rollen erzeugt den wenigsten Abrieb, Schleifen den meisten.

Beim Abrollen von Tonnen oder Rollen oder Nadeln wird jedoch wegen unterschiedlicher Radialgeschwindigkeiten kein reines Abrollen erzielt, welches durch die Reibung Partikel emittiert, welche nachteilig sind.

Um einen dauerhaften galvanischen Kontakt zwischen den nicht rotierten Elektroden der elektrostatischen Baugruppe und dem rotierbaren Halter zu gewährleisten, kann insbesondere die elektrostatische Baugruppe gefedert vorgespannt die Rollelemente und den Halter stützen, ohne jedoch den Halter wesentlich, d.h. insbesondere mikroskopisch oder makroskopisch, zu verformen.

Es ist also konstruktiv vorgesehen, dass in der mechanischen Wirkungskette Halter, Rollelement, Elektrode, (nicht näher spezifizierte) Unterlage mindestens eine Feder als elastisches und elektrisch leitfähiges Element aufgenommen wird. Die Unterlage kann das Gestell sowie die weiteren Teile der mechanischen Baugruppe mit den Bewegungsvorrichtungen für die anderen Freiheitsgrade darstellen.

Kommt der Einsatz der Feder zwischen Halter und Rollelement, erzeugt dies unerwünschten Abrieb.

In einer weiteren Ausführungsform kann das Rollelement die Federeigenschaft aufweisen, insbesondere als leitfähiger Elastomerblock ähnlich wie ein Ball funktionsintegriert sein. Es ist möglich, das Rollelement als elastischer, federnder, kugeliger Käfig zu gestalten.

In einer weiteren Ausführungsform kann die Elektrode geführt werden und die Feder die Vorspannkraft zwischen Elektrode und Unterlage ausüben.

In einer anderen bevorzugten Ausführungsform kann die stehende, nicht rotierbare elektrostatische Baugruppe zur Vorspannung der Rollenelemente insbesondere positionsgeregelt (mit Weggeber, Aktuator, Auswerteeinheit) den Kontakt herstellen.

Für eine Ausführungsform ohne Rollenelemente ist die Positionsregelung der elektrostatischen Baugruppe in Bezug auf den Halter für die Optimierung des Abstandes und dadurch der Haltekraft von Vorteil.

### Weitere Eigenschaften

Die thermischen Eigenschaften des Halters sind bei der Auslegung zu berücksichtigen. Darunter fallen die thermische Wärmekapazität, die thermische Wärmedehnung und die Temperaturstabilität.

Die Wärmekapazität der erfindungsgemäßen Substrathalterung, insbesondere des Halters, ist möglichst klein, um ein Speichern von Wärme zu verhindern.

Bei den meisten Festkörpern unterscheidet sich, bei moderaten Temperaturen und Drücken, die Wärmekapazität bei konstantem Volumen nur marginal von der Wärmekapazität bei konstantem Druck. Im weiteren Verlauf der Schrift wird daher nicht zwischen den beiden Wärmekapazitäten unterschieden.

Des Weiteren werden spezifische Wärmekapazitäten angegeben. Die spezifische Wärmekapazität ist kleiner als 20 kJ/(kg*K), vorzugsweise kleiner als 10 kJ/(kg*K), noch bevorzugter kleiner als 1 kJ/(kg*K), am bevorzugtesten kleiner als 0.5 kJ/(kg*K), am aller bevorzugtesten kleiner als 0.1 kJ/(kg*K).

Der thermische Ausdehnungskoeffizient der Substrathalterung und insbesondere des Halters sollte möglichst klein sein, um eine Verzerrung des Halters durch die Temperaturdifferenzen zu verhindern. Der lineare thermische Ausdehnungskoeffizient ist kleiner als 10⁻⁴K⁻¹, vorzugsweise kleiner als 5^{∗}10⁻⁵K⁻¹, noch bevorzugter kleiner als 10⁻⁵K⁻¹, am bevorzugtesten kleiner als 5^{∗}10⁻⁶K⁻¹, am bevorzugtesten kleiner als 10⁻⁶K⁻¹, am aller bevorzugtesten kleiner als 10⁻⁷K⁻¹.

Die dielektrischen Eigenschaften des Halters können mit der relativen Permittivität (Angaben bei zwischen 0 Hz und100 Hz gemessen) hinreichend genau beschrieben werden. So ist für das Material des Halters eine Permittivität größer 1, bevorzugt größer 1,5 besonders bevorzugt größer 2 vorgesehen.

Der spezifische elektrische Widerstand des Halters, zumindest der Haltefläche soll bevorzugt zwischen 5 × 10^9 Ωcm und 8 × 10^10 Ωcm liegen.

Der Widerstand des Halters soll in einer bevorzugten Ausführungsform so niedrig sein, dass bei Plasmaprozessierung die auftreffenden elektrischen und/oder elektrostatischen Ladungen in weniger als 5 Sekunden, bevorzugt weniger als 2 Sekunden, besonders bevorzugt weniger als 1 Sekunde, im Optimalfall weniger als 0,5 Sekunden abgeleitet werden.

In einer bevorzugten Ausführungsform des Halters wird eine gezielte elektrische Leitfähigkeit durch vergrabene elektrische Leiter und/oder Leiterbahnen erzielt.

In einer weiteren bevorzugten Ausführungsform wird eine bestimmte elektrische Leitfähigkeit mittels Dotierung erreicht. Insbesondere zur Herstellung von Leiterbahnen können hochdotierte Regionen und Pfade erzeugt werden.

Das Material des Dielektrikums und/oder der Beschichtung kann unter anderem folgende Werkstoffe beinhalten:
- Aluminium sowie dessen Oxide und/oder Nitride und/oder Karbide,
- Silizium sowie dessen Oxide und/oder Nitride und/oder Karbide und Kristallisationsformen wie alpha-Si,
- Titan sowie dessen Oxide und/oder Nitride und/oder Karbide,
- Zirkonium sowie dessen Oxide und/oder Nitride und/oder Karbide,
- Yttrium sowie dessen Oxide und/oder Nitride und/oder Karbide,
- Kohlenstoff, auch als Graphit insbesondere pyrolytisch abgeschieden oder Kohlenstoff in diamantenähnlicher Form (diamond-like carbon, DLC).

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1: Schematischer Funktions- und Strukturplan einer Bearbeitungsanlage mit einer erfindungsgemäßen Substrathalterung,
- Fig. 2a: Schematischer Funktionsplan einer beispielhaften Ausführungsform,
- Fig. 2b: Schematischer Funktionsplan einer anderen beispielhaften Ausführungsform,
- Fig. 2c: Schematischer Funktionsplan einer anderen beispielhaften Ausführungsform,
- Fig. 3a: Schematische Schnittdarstellung eines Teils einer anderen Ausführungsform,
- Fig. 3b: Schematische Schnittdarstellung eines Teils einer anderen Ausführungsform,
- Fig. 4a: Schematische Prinzipskizze einer anderen Ausführungsform,
- Fig. 4b: Schematische Prinzipskizze einer anderen Ausführungsform,
- Fig. 5: Schematische Prinzipdarstellung eines Halters einer anderen Ausführungsform.

In den Figuren sind gleiche Bauteile oder Bauteile mit der gleichen Funktion mit den gleichen Bezugszeichen gekennzeichnet.

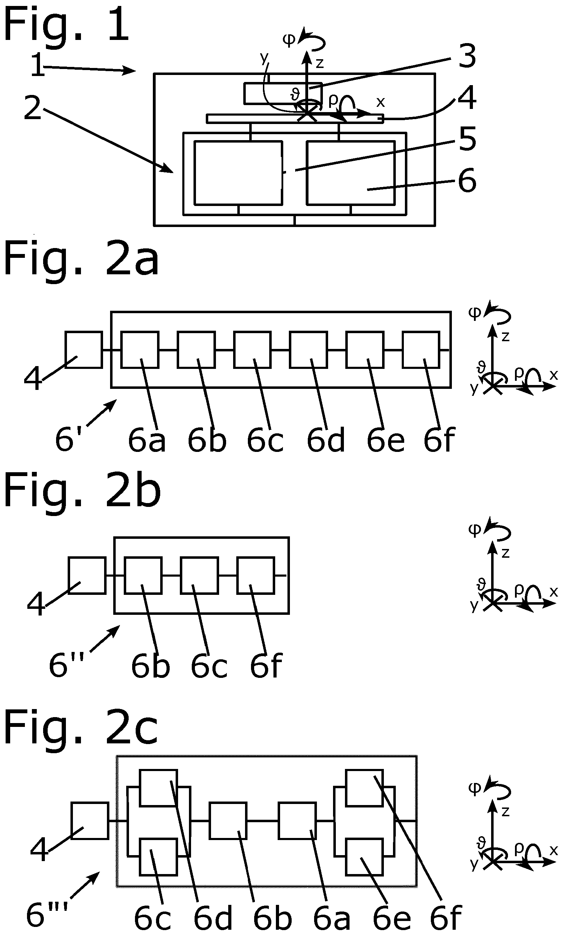

Fig. 1 zeigt einen schematischen Funktions- und Strukturplan einer Bearbeitungsanlage 1 mit einer erfindungsgemäßen Substrathalterung 2 sowie beispielhaften Unterfunktionen. Die Z-Richtung bzw. Z-Achse verläuft senkrecht bzw. als Flächennormale zur Haltefläche. Die X-, Y-Richtungen bzw. Achsen verlaufen senkrecht zueinander und parallel zur bzw. in der Haltefläche des Halters.

Eine Rotation um die x-Achse wird mit ρ, eine Rotation um die y-Achse wird mit ϑ und eine Rotation um die z-Achse wird mit ϕ bezeichnet.

Die Bearbeitungsanlage 1, insbesondere eine Vakuum- und/oder Hochvakuum- und/oder Ultrahochvakuumanlage, ausgeführt insbesondere als Beschichtungs- und/oder Füge- (Bond-) und/oder Bedampfungs- und/oder Plasmaanlage zur Oberflächenveränderung wie Oxidentfernung, Funktionalisierung einer Oberfläche wie Amorphisierung, wird mit der Hauptfunktion im Strukturplan dargestellt.

Die Bearbeitungsanlage 1 erfüllt die Hauptfunktion mittels einer Bearbeitungseinrichtung 3. Die Bearbeitungsanlage 1 beinhaltet die erfindungsgemäße Substrathalterung 2, welche in Verbindung mit einem Substrat 4 steht, also das Substrat 4 befestigt und/oder bewegt.

Die Funktionalität der Substrathalterung 2 ist in eine elektrostatische Baugruppe 5 (Stator 5) und in eine mechanische Baugruppe 6 (Rotor 6) unterteilt, die gemeinsam auf das Substrat 4 wirken. Somit kann die Substrathalterung 2 die erfindungsgemäßen Bewegungsabläufe während der Bearbeitung des Substrates 4 durchführen.

Die Verbindungslinien deuten auf eine logische und/oder materielle Kopplung der einzelnen aufgeführten Teile, es sind jedoch Mess- und/oder Regel- und/oder Versorgungssysteme oder die Bearbeitung des Substrats 4 nicht bildlich aufgeführt. Es werden insbesondere Messaufnehmer, Datenspeicher, Logikschaltungen, Energie-, Pneumatik-, Hydraulik-, sowie Materialflüsse und Zusammenhänge nicht dargestellt.

Fig. 2a zeigt einen schematischen Funktionsplan einer ersten beispielhaften Ausführungsform einer mechanischen Baugruppe 6' der erfindungsgemäßen Substrathalterung 2.

Die logische Reihenfolge der Aufteilung von sechs Bewegungsfreiheitsgraden für die mechanische Baugruppe 6' ist in der Ausführungsform seriell aufgebaut. So wird vom Substrat 4 aus gesehen eine Translation in z-Richtung 6a ausgeführt, welche ein Heben sowie Senken des Substrates 4 ausführt, insbesondere für die Einstellung eines Abstandes zwischen der Bearbeitungseinrichtung 3 und dem Substrat 4.

In Bezug auf den nächsten Freiheitsgrad wird das Substrat 4 mit einer entsprechenden Vorrichtung 6b um die Achse z in ϕ rotiert. Für die Bewegung einer Rotation um die y-Achse 6c sowie eine Rotation um die x-Achse 6d werden entsprechende Vorrichtungen verwendet.

In einer alternativen Ausführungsform sind 6c und 6d miteinander vertauschbar, sodass insbesondere eine nicht dargestellte kardan'sche Anordnung und/oder ein Kugelkalottendesign für die Rotationen als gleichwertig zueinander zu betrachten sind. Somit kann ein eine innozente, fehlerarme Gestalt der Substrathalterung erreicht werden.

Für die Namenskonvention der restlichen Translationen gilt, dass sie miteinander ebenfalls vertauschbar sein können, wobei hier vom Substrat 4 in Bezug auf den fünften Freiheitsgrad eine Translation in y-Richtung 6e ausgeführt wird und in Bezug auf den letzten bzw. sechsten Freiheitsgrad eine Translation in x-Richtung 6f erfolgt.

Somit sind alle Bewegungsfreiheitsgrade von der erfindungsgemäßen Substrathalterung abgedeckt, es können jedoch Redundanzen und/oder zusammengesetzte Antriebe der Bearbeitungsanlage 1 wie eine Auftrennung einer Bewegung insbesondere in Grobpositionierung und Feinpositionierung erfolgen.

Fig. 2b ist ein schematischer Funktionsplan einer zweiten beispielhaften Ausführungsform einer mechanischen Baugruppe 6" der erfindungsgemäßen Substrathalterung 2.

Dabei kann die mechanische Baugruppe 6" vom Substrat 4 aus gesehen die Freiheitsgrade der Rotation um die z-Achse 6b, der Rotation um die y-Achse 6c sowie die Translation in der x-Richtung 6f ausführen. Es ist in einer weiterführenden, nicht dargestellten, Ausführungsform eine andere Reihenfolge der Koordinatenachsen und entsprechenden Antriebe möglich, sodass statt der Translation in der x-Richtung 6f die Translation in der y-Richtung 6e erfolgt. Sodann wird die Rotation um die x-Achse 6d durchgeführt. Die Rotation um die x-Achse 6b wird als erfindungsgemäße Funktion beibehalten.

Fig. 2c ist ein schematischer Funktionsplan einer dritten beispielhaften Ausführungsform einer mechanischen Baugruppe 6'" der erfindungsgemäßen Substrathalterung 2. Es stellt eine mögliche Kombination der Bewegungsfreiheitsgrade dar, wobei durch die Parallelisierung insbesondere die Anwendung von Direktantrieben und integrierten Funktionalitäten, insbesondere Mess- und Regelungssysteme für die Positionserfassung sowie Stabilisierung und/oder aktive Schwingungsdämpfung und/oder aktive Kühlung, und/oder aktive Temperaturstabilisierung und/oder Selbsthaltevermögen erfindungsgemäß bevorzugt ist.

So wird vom Substrat 4 betrachtet eine innozente, fehlerarme Anordnung der beiden Rotationen um die y-Achse 6c und um die x-Achse (6d) auch mit der nachgeschalteten Rotation um die z-Achse 6b erreicht. Dies ist zur Verminderung, in besonderen Ausführungsformen zur Eliminierung von Kippfehlern erster Ordnung der Substrathalterung vorteilhaft.

Nach den Rotationsfreiheitsgraden 6c,6d,6b wird die Translation in der x-Richtung 6a sowie in einer Parallelanordnung die Translation in der y-Richtung 6e und die Translation in der x-Richtung 6f ausgeführt. Die Vorteile für diese besonders bevorzugte Ausführungsform liegen weiterhin in der reduzierten Anzahl der Einzelbewegungskomponenten, falls kombinierte Antriebe, insbesondere Direktantriebe verwendet werden.

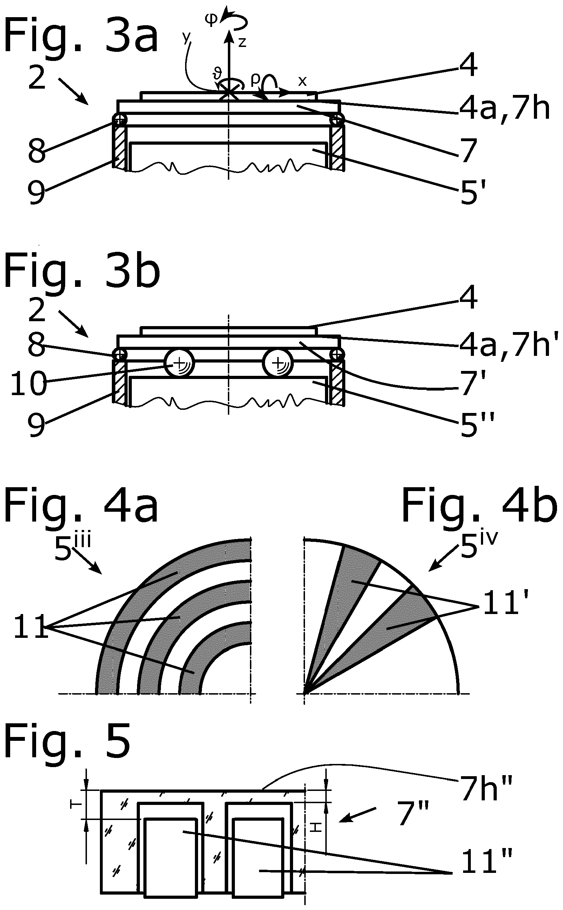

Fig. 3a ist eine schematische, nicht maßstabtreue, Schnittdarstellung in einer Seitenansicht eines Teils einer ersten Ausführungsform der erfindungsgemäßen elektrostatischen Substrathalterung 2.

Das Substrat 4 wird mit einer Substrataußenfläche 4a auf einer Haltefläche 7h eines Halters 7 abgelegt und erfindungsgemäß mittels elektrostatischen Mitteln, welche durch eine elektrostatische Baugruppe 5' dargestellt sind, befestigt.

Der Halter 7 wird mittels Rollelementen 8 zu einer weiteren Bewegungseinrichtung 9 gekoppelt. Diese erfindungsgemäße Ausführungsform zeigt die Substrathalterung 2, welche eine elektrostatische Kraft mittels Coulomb-Effekt entwickelt.

Die Rollelemente 8 können als Lager, insbesondere Axiallager und/oder Axial-Radiallager, gestaltet werden. So können vorteilhaft die Stellen größter Reibung sowie Partikelgenerierung konstruktiv vom Substrat entfernt gestaltet werden.

Durch die Abstände bzw. Leerräume wird eine Entkopplung der rein mechanischen Teile 7, 8 und 9 von der elektrostatischen Baugruppe 5' symbolisiert.

Schematisch sind die Koordinatenrichtungen x,y,z eines kartesischen Koordinatensystems eingezeichnet. Da es sich hier um eine abstrakte funktionale Skizze handelt, werden die Antriebe, und/oder Versorgungseinheiten und/oder Mess- und/oder Regelvorrichtungen nicht bildlich dargestellt. Energie- sowie Materialflüsse und Bewegungsabläufe werden nicht dargestellt.

Fig. 3b ist eine schematische, nicht maßstabtreue, Schnittdarstellung in einer Seitenansicht eines Teils einer zweiten Ausführungsform der erfindungsgemäßen elektrostatischen Substrathalterung 2.

Das Substrat 4 wird mit der Substrataußenfläche 4a auf einer Haltefläche 7h' eines Halters 7' abgelegt und erfindungsgemäß mittels elektrostatischen Mitteln, welche durch eine elektrostatische Baugruppe 5" dargestellt sind, befestigt. Der Halter 7' wird mittels der Rollelemente 8 zur weiteren Bewegungseinrichtung 9 gekoppelt.

Diese erfindungsgemäße Ausführungsform zeigt die Substrathalterung 2, welche die elektrostatische Kraft mittels Johnsen-Rahbek-Effekt entwickelt.

Die Rollelemente 8 können als Lager, insbesondere Axiallager und/oder Axial-Radiallager, gestaltet werden. So können vorteilhaft die Stellen größter Reibung sowie Partikelgenerierung konstruktiv vom Substrat 4 entfernt gestaltet werden.

Elektrostatische Rollelemente 10 verbinden den Halter 7' mit der elektrostatischen Baugruppe 5". Eine elektrostatische Kopplung vom Substrat 4 mit dem Halter 7' sowie mit den elektrostatischen Rollelementen 10 erfolgt mit der elektrostatischen Baugruppe 5".

Eine mechanische Kopplung der Teile 7', 8 mit 9 erfolgt getrennt von der elektrostatischen Kopplung.

Da es sich hier um eine abstrakte funktionale Skizze handelt, werden die Antriebe, und/oder Versorgungseinheiten und/oder Mess- und Regelvorrichtungen nicht bildlich dargestellt. Energie- sowie Materialflüsse und Bewegungsabläufe werden nicht dargestellt.

Fig. 4a stellt eine schematische Prinzipskizze als Draufsicht einer dritten Ausführungsform einer erfindungsgemäßen elektrostatischen Baugruppe 5ⁱⁱⁱ dar. Dabei verlaufen Elektroden 11 als konzentrische Ringe.

Die Elektroden 11 können insbesondere mit der Schaltung mindestens einer Quelle und mindestens einer Senke die elektrostatische Haltekraft erzeugen. Werden mehr als ein Paar Elektroden 11 eingesetzt, kann das Substrat 4 mit in einer zweckmäßigen Reihenfolge geschalteten Elektroden 11 flachgezogen und dann festgehalten werden. Erfindungsgemäß ist es wichtig, die Substrate möglichst mit geringer Verzerrung festzuhalten. Zum Flachziehen kann insbesondere zuerst ein Elektrodenpaar bei geringem Durchmesser die Mitte des Substrats befestigen und nach und nach werden die Elektroden bei größeren Durchmessern geschaltet. Dies führt zu einem kontinuierlichem Flachziehen, sodass das rückgedünnte Substrat keine zusätzliche Welligkeit bzw. Zwang ausgesetzt wird.

Fig. 4b stellt eine schematische Prinzipskizze einer Draufsicht einer vierten Ausführungsform einer erfindungsgemäßen elektrostatischen Baugruppe 5^{iv} dar. Dabei verlaufen Elektroden 11' als Kreissektoren.

Die Elektroden 11' können mit Schaltung mindestens einer Quelle und mindestens einer Senke die elektrostatische Haltekraft erzeugen. Werden mehr als ein Paar Elektroden 11' eingesetzt, kann das Substrat 4 mit in einer zweckmäßigen Reihenfolge geschalteten Elektroden 11' flachgezogen und dann festgehalten werden. Insbesondere können einander gegenüberliegende Elektroden geschaltet werden, sodass es zu einem sukzessiven Ausrollen und Festhalten kommen kann.

Weitere Formen der Elektroden 11,11' sowie Elektrodenpaare werden nicht dargestellt; es ist jedoch erfindungsgemäß möglich, flächenoptimiert insbesondere kreisrunde oder sechseckige oder viereckige Elektroden zu verwenden.

Fig. 5 stellt eine schematische Prinzipdarstellung in einer Seitenansicht eines Halters 7" einer weiteren Ausführungsform der erfindungsgemäßen elektrostatischen Substrathalterung 2 dar.

Eine Haltefläche 7h" ist insbesondere plan (eben) ausgeführt. Ein Abstand T stellt einen Abstand der Haltefläche 7h" von Elektroden 11" dar.

Der Abstand T kann für die Auslegung der elektrostatischen Kraft für Simulationszwecke verwendet werden und ist bevorzugt minimal.

In dieser erfindungsgemäßen Ausführungsform sind die Elektroden 11" in radialen Vertiefungen des Halters 7" angebracht.

Der Halter 7" ist rotierbar und die Elektroden 11" sind feststehend (im Bezug zum Halter 7") ausgeführt.

Ein Abstand H zeigt die insbesondere optimierte funktionelle Höhe, insbesondere die Dicke des Halters 7",

Der Schutzbereich des europäischen Patents wird durch die Patentansprüche bestimmt.

### Elektrostatische Substrathalterung

### Bezugszeichenliste

- 1: Bearbeitungsanlage
- 2: Substrathalterung
- 3: Bearbeitungseinrichtung
- 4: Substrat
- 4a: Substrataußenseite
- 5, 5', 5", 5ⁱⁱⁱ. 5^{iv}: Stator/elektrostatische Baugruppe
- 6, 6', 6",6"': Rotor/mechanische Baugruppe
- 6a: Translation in z-Richtung
- 6b: Rotation um die z-Achse, in ϕ
- 6c: Rotation um die y-Achse, in ϑ
- 6d: Rotation um die x-Achse, in ρ
- 6e: Translation in y-Richtung
- 6f: Translation in x-Richtung
- 7, 7',7": Halter
- 7h, 7h',7h": Haltefläche
- 8: Rollelement
- 9: Bewegungsvorrichtung
- 10: elektrostatisches Rollelement
- 11, 11', 11",: Elektrode
- x,y,z: Achsen des kartesischen Koordinatensystems

## Patentansprüche

1. Elektrostatische Substrathalterung (2) zur Aufnahme und Halterung eines Substrats (4), aufweisend:
- einen Rotor (6, 6', 6",6‴), aufweisend einen Halter (7,7',7") zur Fixierung des Substrats (4) auf einer Haltefläche (7h, 7h', 7h"),
- einen Stator (5, 5', 5", 5ⁱⁱⁱ, 5^{iv}) zur Aufnahme und Lagerung des Rotors (6, 6', 6",6‴),
- Elektroden (11,11',11") zur Erzeugung einer elektrostatischen Haltekraft zur Fixierung des Substrats (4), wobei die Elektroden (11,11',11") die elektrische Haltekraft auf das Substrat (4) ausüben,
wobei der Stator (5, 5', 5", 5ⁱⁱⁱ. 5^{iv}) die Elektroden (11, 11`, 11") aufweist, wobei die Elektroden (11, 11', 11") von der Haltefläche (7h, 7h',7h") beabstandet sind,
wobei der Rotor (6,6',6",6"') durch elektrisch leitfähige Lagerelemente (10) gelagert ist,
wobei die elektrisch leitfähigen Lagerelemente (10) die Elektroden (11, 11', 11") des Stators (5, 5', 5", 5ⁱⁱⁱ. 5^{iv}) berühren.

2. Elektrostatische Substrathalterung (2) nach Anspruch 1, wobei der Rotor (6,6',6",6'") durch Kugellager und/oder Rillenkugellager und/oder Schrägkugellager und/oder Tonnenlager und/oder Axiallager und/oder Radiaxlager, gelagert ist.

3. Elektrostatische Substrathalterung (2) nach einem der vorhergehenden Ansprüche, wobei die Dicke des Halters (7,7',7") in Z-Richtung weniger als 100 mm, bevorzugt weniger als 50 mm, besonders bevorzugt weniger als 10 mm, ganz besonders bevorzugt weniger als 5 mm beträgt.

4. Elektrostatische Substrathalterung (2) nach einem der vorhergehenden Ansprüche, wobei der Abstand zwischen den Elektroden (11, 11', 11") und der Haltefläche (7h,7h',7h") weniger als 100 Millimeter beträgt.

5. Elektrostatische Substrathalterung (2) nach einem der vorhergehenden Ansprüche, wobei auf der dem Substrat (4) abgewandten Seite des Halters (7,7',7") Vertiefungen angeordnet sind, in denen die Elektroden (11,11',11") angeordnet sind, wobei die Vertiefungen insbesondere konzentrisch und/oder als Kanäle ausgebildet sind.

6. Elektrostatische Substrathalterung (2) nach einem der vorhergehenden Ansprüche, wobei die Elektroden (11,11',11") als Ringe (11) ausgebildet sind, insbesondere sind die Ringe (11) äquidistant und/oder konzentrisch angeordnet.

7. Elektrostatische Substrathalterung (2) nach einem der vorhergehenden Ansprüche, wobei die Elektroden (11, 11', 11") als Kreissektoren (11') und/oder Kreisringsektoren ausgebildet sind.

8. Elektrostatische Substrathalterung (2) nach einem der vorhergehenden Ansprüche, wobei der Halter (7,7',7") als Wabenstruktur ausgebildet ist.

9. Elektrostatische Substrathalterung (2) nach einem der vorhergehenden Ansprüche, aufweisend ein Positionier-, Halte- und Bewegungssystem zur Bewegung des Substrats (4) und/oder des Halters (7,7',7").

10. Elektrostatische Substrathalterung (2) nach einem der vorhergehenden Ansprüche, wobei das Substrat (4) und/oder der Halter (7,7',7") in mindestens drei Freiheitsgraden beweglich ist, bevorzugt in mindestens vier Freiheitsgraden, bevorzugter in mindestens fünf Freiheitsgraden, am bevorzugtesten in allen sechs Freiheitsgraden.

11. Elektrostatische Substrathalterung (2) nach einem der vorhergehenden Ansprüche, wobei das Positionier-, Halte- und Bewegungssystem für mindestens einen Freiheitsgrad mit einem Grobantrieb und einem Feinantrieb ausgebildet ist.

12. Elektrostatische Substrathalterung (2) nach einem der vorhergehenden Ansprüche, wobei die Antriebe des Positionier-, Halte- und Bewegungssystems derart ausgelegt sind, dass sie in einem nicht bewegten Zustand ohne Betriebsspannung und/oder Strom und/oder andere Energiezufuhr die jeweilige Position beibehalten und/oder arretieren können.

13. Elektrostatische Substrathalterung (2) nach einem der vorhergehenden Ansprüche, aufweisend eine zentrale Steuereinheit und/oder Regeleinheit zur Steuerung und/oder Regelung von Bewegungen und/oder Abläufen, insbesondere der Fixierung des Substrates (4), der Position des Halters (7,7',7"), der Geschwindigkeiten und/oder der Beschleunigungen des Halters (7,7',7").

14. Elektrostatische Substrathalterung (2) nach einem der vorhergehenden Ansprüche, aufweisend mindestens einen Sensor zur Messung von Einflussfaktoren, insbesondere ein Abstands- und/oder Positionssensor, und mindestens einen Aktor zur Steuerung und/oder Regelung in Abhängigkeit der gemessenen Einflussfaktoren, insbesondere ein Positionsgeber und/oder Winkelgeber.

15. Bearbeitungsanlage (1), aufweisend eine Bearbeitungseinrichtung (3) zur Bearbeitung eines Substrats (4) und eine elektrostatische Substrathalterung (2) zur Halterung des Substrats (4) nach einem der vorhergehenden Ansprüche.

16. Verfahren zur Bearbeitung eines Substrats (4), wobei das Substrat (4) durch eine elektrostatische Substrathalterung (2) nach einem der Ansprüche 1-14 gehalten und rotiert wird.

## Claims

1. An electrostatic substrate holder (2) for mounting and holding a substrate (4), comprising:
- a rotor (6, 6', 6", 6'"), comprising a holder (7, 7', 7") for fixing the substrate (4) on a holding surface (7h, 7h', 7h"),
- a stator (5, 5', 5", 5ⁱⁱⁱ, 5^{iv}) for receiving and mounting the rotor (6, 6', 6", 6‴),
- electrodes (11, 11', 11") for producing an electrostatic holding force for fixing the substrate (4), wherein the electrodes (11, 11', 11") exert the electrical holding force on the substrate (4),
wherein the stator (5, 5', 5", 5ⁱⁱⁱ, 5^{iv}) comprises the electrodes (11, 11', 11"), wherein the electrodes (11, 11', 11") are spaced apart from the holding surface (7h, 7h', 7h"),
wherein the rotor (6, 6', 6", 6'") is mounted by electrically conductive bearing elements (10),
wherein the electrically conductive bearing elements (10) contact the electrodes (11, 11', 11") of the stator (5, 5', 5", 5ⁱⁱⁱ, 5^{iv}).

2. The electrostatic substrate holder (2) according to claim 1, wherein the rotor (6, 6', 6", 6‴) is mounted by means of ball bearings and/or grooved ball bearings and/or angular ball bearings and/or spherical roller bearings and/or axial bearings and/radial bearings.

3. The electrostatic substrate holder (2) according to any one of the preceding claims, wherein the thickness of the holder (7, 7', 7") in the Z-direction is less than 100 mm, preferably less than 50 mm, particularly preferably less than 10 mm, very particularly preferably less than 5 mm.

4. The electrostatic substrate holder (2) according to any one of the preceding claims, wherein the distance between the electrodes (11, 11', 11") and the holding surfaces (7h, 7h', 7h") amounts to less than 100 millimetres.

5. The electrostatic substrate holder (2) according to any one of the preceding claims, wherein recesses are arranged on the side of the holder (7, 7', 7") facing away from the substrate (4), in which the electrodes (11, 11', 11") are arranged, wherein the recesses are constituted in particular concentrically and/or as channels.

6. The electrostatic substrate holder (2) according to any one of the preceding claims, wherein the electrodes (11, 11', 11") are constituted as rings (11), in particular the rings (11) are arranged equidistant and/or concentric.

7. The electrostatic substrate holder (2) according to any one of the preceding claims, wherein the electrodes (11, 11', 11") are constituted as circular sectors (11') and/or circular ring sectors.

8. The electrostatic substrate holder (2) according to any one of the preceding claims, wherein the holder (7, 7', 7") is constituted as a honeycomb structure.

9. The electrostatic substrate holder (2) according to any one of the preceding claims, comprising a positioning, holding and movement system for moving the substrate (4) and/or the holder (7, 7', 7").

10. The electrostatic substrate holder (2) according to any one of the preceding claims, wherein the substrate (4) and/or the holder (7. 7', 7") is movable in at least three degrees of freedom, preferably in at least four degrees of freedom, more preferably in at least five degrees of freedom, most preferably in all six degrees of freedom.

11. The electrostatic substrate holder (2) according to any one of the preceding claims, wherein the positioning, holding and movement system is constituted for at least one degree of freedom with a coarse drive and a fine drive.

12. The electrostatic substrate holder (2) according to any one of the preceding claims, wherein the drives of the positioning, holding and movement system are designed such that, in an unmoved state without operating voltage and/or current and/or
other energy supply, the respective position can be retained and/or locked.

13. The electrostatic substrate holder (2) according to any one of the preceding claims, comprising a central control unit and/or regulating unit for controlling and/or regulating movements and/or sequences, in particular the fixing of the substrate (4), the position of the holder (7, 7', 7"), the speeds and/or the accelerations of the holder (7, 7', 7").

14. The electrostatic substrate holder (2) according to any one of the preceding claims, comprising at least one sensor for measuring influencing factors, in particular a distance and/or positioning sensor, and at least one actuator for controlling and/or regulating in particular a position sensor and/or an angle sensor, depending on the measuring influencing factors.

15. A processing system (1) comprising a processing device (3) for processing a substrate (4) and an electrostatic substrate holder (2) for holding the substrate (4) according to any one of the preceding claims.

16. A method for processing a substrate (4), wherein the substrate (4) is held and rotated by an electrostatic substrate holder (2) according to any one of claims 1-14.

## Revendications

1. Support de substrat électrostatique (2) pour recevoir et maintenir un substrat (4), présentant :
- un rotor (6, 6', 6", 6‴) présentant un support (7, 7', 7") pour fixer le substrat (4) sur une surface de fixation (7h, 7h', 7h"),
- un stator (5, 5', 5", 5ⁱⁱⁱ, 5^{iv}) pour recevoir et supporter le rotor (6, 6', 6", 6‴),
- des électrodes (11, 11', 11") pour produire une force de fixation électrostatique pour fixer le substrat (4), dans lequel les électrodes (11, 11', 11") exercent la force de fixation sur le substrat (4),
dans lequel le stator (5, 5', 5", 5ⁱⁱⁱ, 5^{iv}) présente les électrodes (11, 11', 11"), dans lequel les électrodes (11, 11', 11") sont distantes de la surface de fixation (7h, 7h', 7h"),
dans lequel le rotor (6, 6', 6", 6"') est supporté par des éléments de palier (10) conducteurs électriques,
dans lequel les éléments de palier (10) conducteurs électriques touchent les électrodes (11, 11', 11") du stator (5, 5', 5", 5ⁱⁱⁱ, 5^{iv}).

2. Support de substrat électrostatique (2) selon la revendication 1, dans lequel le rotor (6, 6', 6", 6"') est supporté par des roulements à billes et/ou des roulements à billes rainurés et/ou des roulements à billes en biais et/ou des roulements à rouleaux sphériques et/ou des roulements axiaux et/ou des roulements radiaux.

3. Support de substrat électrostatique (2) selon l'une des revendications précédentes, dans lequel l'épaisseur du support (7, 7', 7") dans le sens Z est inférieure à 100 mm, de préférence inférieure à 50 mm, particulièrement de préférence inférieure à 10 mm, tout particulièrement de préférence inférieure à 5 mm.

4. Support de substrat électrostatique (2) selon l'une des revendications précédentes, dans lequel la distance entre les électrodes (11, 11', 11") et la surface de fixation (7h, 7h', 7h") est inférieure à 100 millimètres.

5. Support de substrat électrostatique (2) selon l'une des revendications précédentes, dans lequel des creux sont disposés sur le côté du support (7, 7', 7") détourné du substrat (4), dans lesquels les électrodes (11, 11', 11") sont disposées, dans lequel les creux sont formés en particulier concentriques et/ou en tant que canaux.

6. Support de substrat électrostatique (2) selon l'une des revendications précédentes, dans lequel les électrodes (11, 11', 11") sont conçues en tant que bagues (11), en particulier, les bagues (11) sont disposées équidistantes et/ou concentriques.

7. Support de substrat électrostatique (2) selon l'une des revendications précédentes, dans lequel les électrodes (11, 11', 11") sont conçues en tant que secteurs circulaires (11') et/ou en tant que secteurs annulaires.

8. Support de substrat électrostatique (2) selon l'une des revendications précédentes, dans lequel le support (7, 7', 7") est conçu en tant que structure alvéolaire.

9. Support de substrat électrostatique (2) selon l'une des revendications précédentes, présentant un système de positionnement, de fixation et de mouvement pour déplacer le substrat (4) et/ou le support (7, 7', 7").

10. Support de substrat électrostatique (2) selon l'une des revendications précédentes, dans lequel le substrat (4) et/ou le support (7, 7', 7") est mobile dans au moins trois degrés de liberté, de préférence dans au moins quatre degrés de liberté, plus encore de préférence dans au moins cinq degrés de liberté, de manière préférée entre toutes dans tous les six degrés de liberté.

11. Support de substrat électrostatique (2) selon l'une des revendications précédentes, dans lequel le système de positionnement, de fixation et de mouvement est conçu avec un entraînement grossier et un entraînement fin pour au moins un degré de liberté.

12. Support de substrat électrostatique (2) selon l'une des revendications précédentes, dans lequel les entraînements du système de positionnement, de fixation et de mouvement sont ainsi conçus que dans un état non déplacé sans tension de service et/ou courant électrique et/ou
autre apport d'énergie, ils peuvent conserver la position respective et/ou s'arrêter.

13. Support de substrat électrostatique (2) selon l'une des revendications précédentes, présentant une unité de commande centrale et/ou une unité de réglage pour commander et/ou régler des mouvements et/ou des déroulements, en particulier la fixation du substrat (4), la position du support (7, 7', 7"), des vitesses et/ou des accélérations du support (7, 7', 7").

14. Support de substrat électrostatique (2) selon l'une des revendications précédentes, présentant au moins un capteur pour mesurer des facteurs d'influence, en particulier un capteur de distance et/ou de position, et au moins un actionneur pour commander et/ou régler en fonction des facteurs d'influence mesurés, en particulier un indicateur de position et/ou un indicateur angulaire.

15. Installation de traitement (1), présentant un dispositif de traitement (3) pour traiter un substrat (4) et un support de substrat électrostatique (2) pour maintenir un substrat (4) selon l'une des revendications précédentes.

16. Procédé de traitement d'un substrat (4), dans lequel le substrat (4) est maintenu et tourné par un support de substrat électrostatique (2) selon l'une des revendications 1-14.
